# EUROPÄISCHE PATENTANMELDUNG

(11) **EP 0 959 147 A2**
(43) Veröffentlichungstag der Anmeldung: **24.11.1999**
(21) Anmeldenummer: 99105368.7
(22) Anmeldetag: 16.03.1999
(51) Int. Cl.: C23C 14/50, C23C 14/24

(54) **Vorrichtung zum Halten von Linsen**

(30) Priorität: 16.05.1998 DE 19822064
(71) Anmelder: Balzers und Leybold Deutschland Holding Aktiengesellschaft, 63450 Hanau (DE)
(72) Erfinder: Gries, Herbert, 63776 Mömbris (DE); Locher, Stefan, 63775 Alzenau (DE)

(57) **Zusammenfassung**

Bei einer Vorrichtung zum Halten von Linsen für zu beschichtende Brillengläser (3,3',...), mit einem Substrathalter (4), bestehend aus schirmartigen, eine kugelabschnittförmige Schale bildenden, eine Vielzahl von Bohrungen (5,5',...) aufweisenden Blechzuschnitten (4a,b,c,d), der in der Vakuumkammer (2) oberhalb einer Beschichtungsquelle (Q) um eine vertikale Achse (R) drehbar gelagert ist, wobei die Beschichtungsquelle (Q) seitlich der Drehachse (R ) angeordnet und die Linsen (3,3',...) in die Bohrungen (5,5',...) eingesetzt und gehalten sind, schneidet die Mittelsenkrechte (M) der jeweiligen Bohrungslängsachse (A) die Rotationsachse (R) des Substrathalters (4) in einem Ort (O), der etwa mittig zwischen zwei Orten liegt, die die Schnittpunkte (C,F) der Mittelsenkrechten (M',M'') zweier gedachter Bohrungen desselben Bohrungsteilkreises (T) mit der Rotationsachse (R) sind, deren Bohrungslängsachsen (A',A'') die Beschichtungsquelle (Q) schneiden, wobei jedoch die eine gedachte Bohrung den größten und die andere gedachte Bohrung den kürzesten Abstand zur Beschichtungsquelle (Q) aufweist.

## Beschreibung

Die Erfindung betrifft eine Vorrichtung zum Halten von Linsen, insbesondere in einer Vakuum-Aufdampfanlage oder Sputteranlage zu beschichtender Brillengläser, mit einem Substrathalter, bestehend aus schirmartigen, eine kugelabschnittfärmige Schale bildenden, eine Vielzahl von Bohrungen aufweisenden Blechzuschnitten, der in der Vakuumkammer oberhalb einer Beschichtungsquelle um eine vertikale Achse drehbar gelagert ist, wobei die Beschichtungsquelle seitlich der Drehachse angeordnet und die Linsen in die Bohrungen eingesetzt und in den Bohrungen gehalten und zentriert sind.

Bekannt ist eine Vorrichtung der in Frage stehenden Art (US 3,859,956), bei der die zu beschichtenden Linsen in Ringe eingesetzt sind, die ihrerseits von einem Rahmen gehalten sind, der im Abstand oberhalb der Beschichtungsquelle gelagert ist, wobei die Ringe gegenüber dem Rahmen kippbar sind, und zwar derart, daß die Linsen mit ihren gekrümmten Flächen auf die Quelle ausrichtbar sind. Bei dieser Vorrichtung erstreckt sich die Rotationsachse des Rahmens lotrecht durch die Quelle.

Bekannt ist weiterhin eine Vorrichtung zum Halten und Wenden von Linsen, insbesondere für in einer Hochvakuum-Aufdampfanlage oder -Sputteranlage zu beschichtende Brillenglaslinsen (DE-OS 39 21 672), mit einem die zu haltende Linse tragenden Ringpaar, das seinerseits mit einem Substrathalter verbindbar ist, der in der Prozeßkammer der Hochvakuumanlage gehalten ist, wobei das schirmartig bzw. halbschalenartig ausgeformte Blechteil, das den Substrathalter bildet, zumindest teilweise von einem sichelförmigen, einen Schieber oder Rechen bildenden Blechzuschnitt oder Profilelement übergriffen ist, wobei die dem Substrathalter zugewandte kante des Rechens in einem geringen Abstand zur Außenfläche des Substrathalters von einem in der Prozeßkammer angeordneten Gleitstück oder Gelenkarm gehalten ist, wobei der Rehen in dieser Lage gegenüber der Oberseite des Substrathalters um die Rotationsachse des Substrathalters bewegbar ist.

Vorgeschlagen wurde auch eine Vakuum-Beschichtungsanlage zum Aufdampfen von Vergütungsschichten auf optische Substrate (DE-OS 37 15 831), wie Kunststoff-Brillengläser, welche auf Trägermittel aufspannbar sind, die in einem evakuierbaren Rezipienten oberhalb von Verdampfungsquellen umlaufen, wobei die Trägermittel eine Mehrzahl wenigstens angenähert kreissegmentförmige, flächige Trägerplatten umfassen, welche zueinander kalottenförmig sowie je um 180° wendbar an einer gemeinsamen Drehachse abgestützt sind, wobei jede Trägerplatte in Öffnungsbereichen eine Mehrzahl mit mindestens einer Haltefeder versehene Substrat-Halterungen aufweist, von denen mindestens eine nach beiden Seiten aus der Trägerplattenebene bis zu einem vorgegebenen Winkel heraus frei kippbar ist.

Bekannt ist schließlich eine Vorrichtung zum beschichten von linsenförmigen Substraten (US 4,449,478), umfassend einen schirmartigen Substratträger mit einer Vielzahl von auf zwei Teilkreisen angeordneten Bohrungen zur Aufnahme der Linsen, wobei die Bohrungen sämtlich auf die unterhalb des Substratträgers angeordnete Quelle ausgerichtet sind, und zwar derart, daß die Längsachsen der Bohrungen alle in einem Punkt die lotrechte Rotationsachse des Substratträgers schneiden. Die Beschichtungsquelle ist dabei vergleichsweise nahe dem Schnittpunkt der Längsachse vorgesehen.

Der vorliegenden Erfindung liegt die Aufgabe zugrunde, eine Vorrichtung des in Frage stehenden Typs zu schaffen, die eine weitgehend gleichmäßige Beschichtung ermöglicht, und zwar auch mit Anlagen, bei denen die Beschichtungsquelle nicht zentrisch unterhalb des Substratträgers angeordnet ist, sondern außermittig, also neben der Rotationsachse des schirmartigen Substratkörpers. Die Vorrichtung soll auch auf die Eigenarten einer Beschichtungsquelle, beispielsweise die Ausbildung der "Verdampferkeule" einstellbar sein.

Erfindungsgemäß wird diese Aufgabe dadurch gelöst, daß die die umlaufenden kreiszylindrischen Ränder der Linsen umschließenden und zentrierenden Bohrungen jeweils in etwa auf die Beschichtungsquelle ausgerichtet sind, wobei die Mittelsenkrechte der jeweiligen Bohrungslängsachse die Rotationsachse des Substrathalters in einem Ort schneidet, der etwa mittig zwischen zwei Orten liegt, die die Schnittpunkte der Mittelsenkrechten zweier gedachter Bohrungen desselben Bohrungsteilkreises mit der Rotationsachse sind, deren Bohrungslängsachsen die Beschichtungsquelle schneiden, wobei jedoch die eine gedachte Bohrung den größten und die andere gedachte Bohrung den kürzesten Abstand zur Beschichtungsquelle aufweist.

Die beim Beschichten von Kugelflächen von Linsen üblicherweise auftretenden Schrägbeschichtungen, die sogenannten Halbmondeffekte, werden durch das Kippen der Linsen gegenüber der Fläche des Substratträgers um einen bestimmten Winkel weitgehend vermindert. Weitere Einzelheiten und Merkmale sind in den Patentansprüchen näher beschrieben und gekennzeichnet.

Die Erfindung läßt die verschiedensten Ausführungsmöglichkeiten zu; eine davon ist in der anhängenden Zeichnung rein schematisch dargestellt, und zwar zeigen:
- Fig. 1: das der Vorrichtung zugrunde liegende räumliche Gebilde,
- Fig. 2: die perspektivische Darstellung eines Substrathalters in Gestalt von vier halbschalenförmigen, eine Vielzahl von Bohrungen aufweisenden Blechteilen,

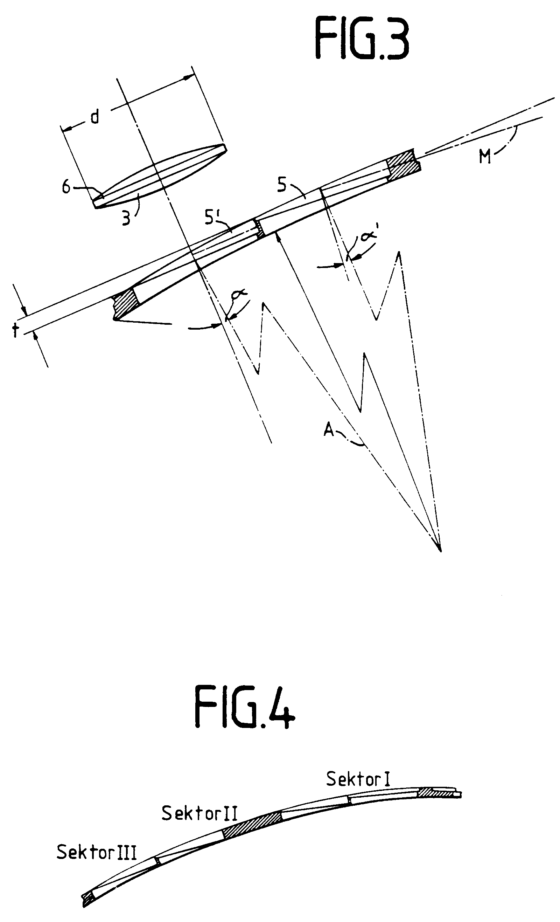

- Fig. 3: einen Teilschnitt gemäß den Linien B-B nach Fig. 2 und
- Fig. 4: einen Schnitt S durch die drei Sektoren eines Blechteils gemäß Fig. 2.

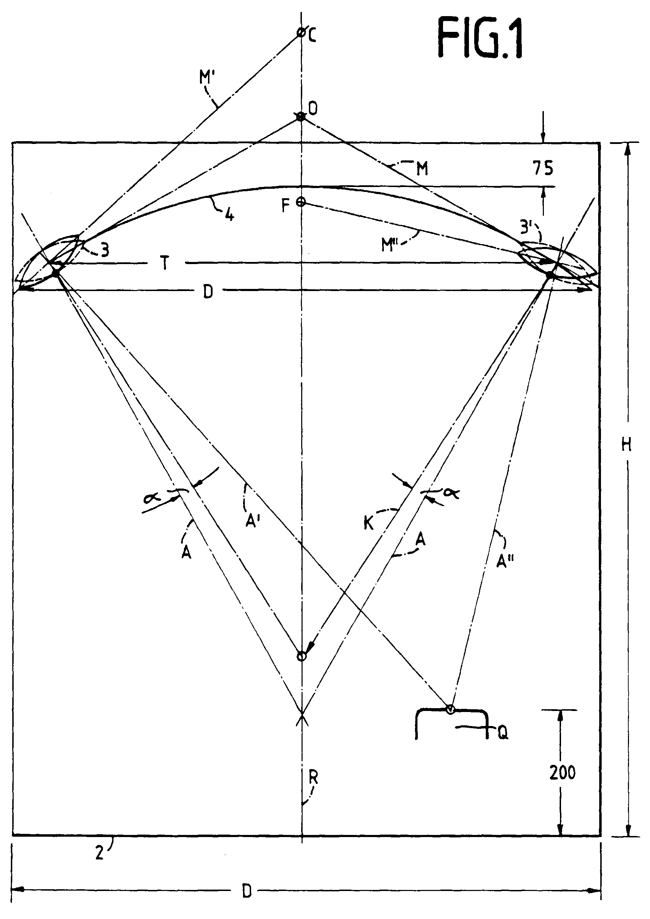

Der Substrathalter 4 besteht im wesentlichen aus vier gleichen Blechzuschnitten 4a,b,c,d, die zusammen eine kugelabschnittförmige Schale bilden, die um eine vertikale Achse R in der Vakuumkammer 2 rotierbar gelagert ist. Wie Fig. 1 zeigt, ist die Wölbung des schalenförmigen Substratträgers 4 bzw. dessen Krümmungsradius K etwas geringer bemessen als der Durchmesser D des Substratträgers 4, wobei alle Bohrungen 5,5',... eines Teilkreises T,T',... etwa auf die Beschichtungsquelle Q ausgerichtet sind, wobei die Mittelsenkrechte M der jeweiligen Bohrungslängsachse A bzw. die zwischen den beiden gekrümmten Flächen der Linse lotrecht auf der optischen Achse stehende Gerade die Rotationsachse R des Substrathalters 4 in einem Ort O schneidet, der etwa mittig zwischen zwei Orten liegt, die die Schnittpunkte C,F der Mittelsenkrechten M',M'' zweier gedachter Bohrungen desselben Bohrungsteilkreises T mit der Rotationsachse R sind, deren Bohrungslängsachsen A',A'' die Beschichtungsquelle schneiden, wobei jedoch die eine gedachte Bohrung den größten und die andere gedachte Bohrung den kürzesten Abstand zur Beschichtungsquelle Q aufweist.

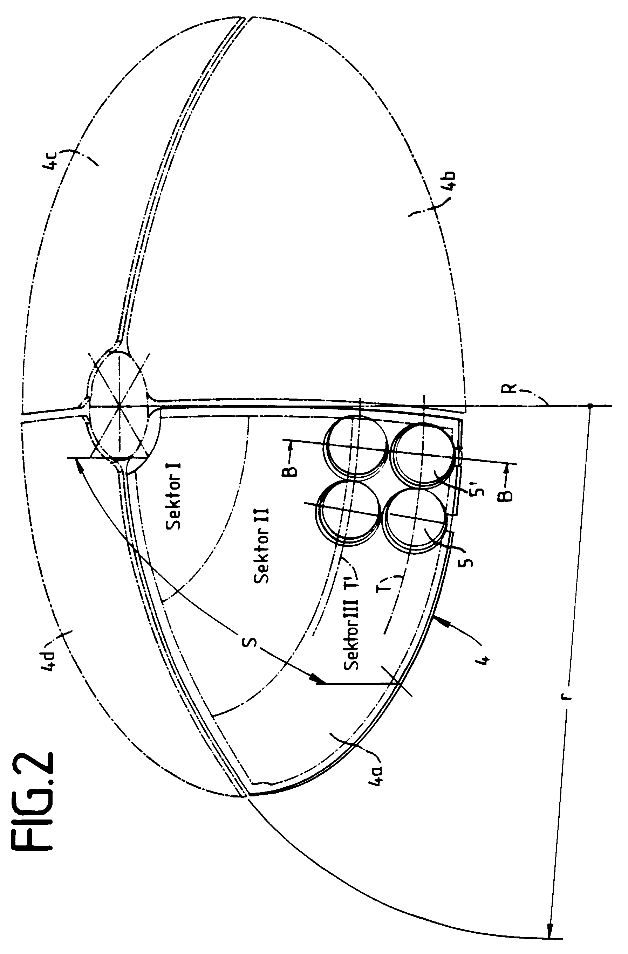

Wie Fig. 2 zeigt, ist der Substratträger 4 aus vier gleichen Blechzuschnitten 4a,b,c,d zusammengesetzt, wobei jeder dieser vier Blechzuschnitte in drei Zonen I bis III eingeteilt ist und für jeden Sektor in einer Tabelle die jeweiligen (angenäherten) Korrekturwinkel α aufgeführt sind. Diese Korrekturwinkel α ergeben sich für die verschiedenen Teilkreise T,T',... oder Sektoren, von denen zwei in Fig. 2 angedeutet sind. Je nach dem vorgegebenen Linsendurchmesser können mehr oder weniger Teilkreise T,T',... vorgesehen sein, wobei für die Bohrungen 5,5',... jeweils der Korrekturwert des Sektors I bis III vorgesehen wird, in den der Teilkreis fällt. (Die vier in Fig. 2 angedeuteten Bohrungen 5,5',... sind danach alle dem Sektor III zugeordnet.)

In den nachfolgenden Tabellen sind Beispiel für die Hauptabmessungen von Aufdampfanlagen angegeben, wobei die zweite Tabelle die Korrekturwinkel α für eine Anlage mit einem Substratträger 4 mit einem Krümmungsradius K von 750 mm Länge und für Linsen mit einem Durchmesser d = 65 mm angibt, wobei die Winkel α,... jeweils um einen geringen Wert korrigiert sind, der sich aus der Gestalt und Größe der Plasmawolke (Dampfkeule) einer ganz bestimmten Verdampferquelle ergibt und in praktischen Versuchsreihen ermittelt ist.

| ∅ D | H | K |
|---|---|---|
| 550 | 580 | 400 |
| 725 | 710 | 500 |
| 950 | 1110 | 750 |
| 1110 | 1110 | 750 |
| 1500 | 1500 | 1000 |

| Sektor | I | II | III |
|---|---|---|---|
| α [°] | 1,5 | 4,0 | 5,5 |
| t [mm] | 0,9 - 0,2 | 2,3 - 0,2 | 3,2 - 0,2 |

### Bezugszeichenliste

- 2: Vakuumkammer
- 3,3',...: Brillenglas, Linse
- 4: Substrathalter
- 5,5',...: Bohrung
- 6,6',...: Linsenrand
- A,A',...: Bohrungslängsachse
- C: Schnittpunkt
- D: Durchmesser
- F: Schnittpunkt
- K: Krümmungsradius
- M,M',...: Mittelsenkrechte
- O: Schnittpunkt
- Q: Beschichtungsquelle
- R: Drehachse
- T: Bohrungsteilkreis

## Patentansprüche

1. Vorrichtung zum Halten von Linsen, insbesondere für in einer Vakuum-Aufdampfanlage oder Sputteranlage zu beschichtende Brillengläser (3,3',...), mit einem Substrathalter (4), bestehend aus schirmartigen, eine kugelabschnittförmige Schale bildenden, eine Vielzahl von Bohrungen (5,5',...) aufweisenden Blechzuschnitten (4a,b,c,d), der in der Vakuumkammer (2) oberhalb einer Beschichtungsquelle (Q) um eine vertikale Achse (R) drehbar gelagert ist, wobei die Beschichtungsquelle (Q) seitlich der Drehachse (R ) angeordnet und die Linsen (3,3',...) in die Bohrungen (5,5',...) eingesetzt und in den Bohrungen (5,5',...) gehalten und zentriert sind, **dadurch gekennzeichnet,** daß die die umlaufenden kreiszylindrischen Ränder (6,6',...) der Linsen (3,3',...) umschließenden und zentrierenden Bohrungen (5,5',...) jeweils in etwa auf die Beschichtungsquelle (Q) ausgerichtet sind, wobei die Mittelsenkrechte (M) der jeweiligen Bohrungslängsachse (A) die Rotationsachse (R) des Substrathalters (4) in einem Ort (O) schneidet, der etwa mittig zwischen zwei Orten liegt, die die Schnittpunkte (C,F) der Mittelsenkrechten (M',M'') zweier gedachter Bohrungen desselben Bohrungsteilkreises (T) mit der Rotationsachse (R) sind, deren Bohrungslängsachsen (A',A'') die Beschichtungsquelle (Q) schneiden, wobei jedoch die eine gedachte Bohrung den größten und die andere gedachte Bohrung den kürzesten Abstand zur Beschichtungsquelle (Q) aufweist.

2. Vorrichtung nach Anspruch 1, **dadurch gekennzeichnet,** daß die Bohrungen (5,5',...) als konzentrische Zweistufenbohrungen ausgebildet sind, wobei die der Beschichtungsquelle (Q) abgekehrte erste, geringfügig größer bemessene Bohrungsstufe dem Außendurchmesser der Linsen entspricht.

3. Vorrichtung nach den Ansprüchen 1 und 2, **dadurch gekennzeichnet,** daß alle auf einem Teilkreis (T,T',...) angeordneten Bohrungen den gleichen Winkel (α) mit der Rotationsachse (R) einschließen.

4. Vorrichtung nach den vorhergehenden Ansprüchen, **dadurch gekennzeichnet,** daß in Abhängigkeit der Leistung der Beschichtungsquelle (Q), insbesondere der Gestalt und Größe der von ihr ausgehende Plasmawolke, alle auf die Beschichtungsquelle ausgerichteten Bohrungen (5,5',...) zur Halterung der Linsen (3,3',...) in ihrer Winkelstellung (α) zur Rotationsachse (R) um einen zusätzlichen Korrekturwinkel verändert werden, wobei dieser Korrekturwinkel mit größer werdender Plasmawolke abnimmt und umgekehrt.
